Europäisches Patentamt

European Patent Office

Office européen des brevets

(19)

(11) **EP 0 919 818 B1**

(12) **EUROPEAN PATENT SPECIFICATION**

(45) Date of publication and mention
of the grant of the patent:
**05.02.2003 Bulletin 2003/06**

(51) Int Cl.⁷: **G01R 13/34**, G01D 1/00

(21) Application number: **97309639.9**

(22) Date of filing: **28.11.1997**

(54) **Method and apparatus for displaying waveforms**

Verfahren und Vorrichtung zum Darstellen von Wellenformen

Procédé et appareil pour la présentation des formes d'ondes

(84) Designated Contracting States:
**DE FR GB**

(43) Date of publication of application:
**02.06.1999 Bulletin 1999/22**

(73) Proprietor: **FLUKE CORPORATION
Everett, Washington 98206-9090 (US)**

(72) Inventor: **Vertregt, Maarten,
c/o Ned Philips Bedr. B.V.
5656 AA Eindhoven (NL)**

(74) Representative: **Burke, Steven David et al
R.G.C. Jenkins & Co.
26 Caxton Street
London SW1H 0RJ (GB)**

(56) References cited:
**US-A- 5 515 457**

• **PATENT ABSTRACTS OF JAPAN vol. 95, no. 8,
29 September 1995 & JP 07 131294 A
(YOKOGAWA ELECTRIC CORP), 19 May 1995,**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

This invention relates to methods and apparatus for displaying waveforms, and particularly but not exclusively to oscilloscopes.

There are a number of techniques for sampling a signal and then providing a visual display representing the waveform of the signal. One example, using a digital storage oscilloscope, is described in WO-A-96/37785. Generally speaking, in a digital oscilloscope, each sample of the input waveform is mapped to a particular position on the display. Depending upon the nature of the input waveform, this can give rise to a waveform represented by individual dots, formed by respective picture elements (pixels) or groups of pixels on the display.

It would be desirable to provide a more representative display, by linking the dots together, and this can be achieved using interpolation to select for display additional pixels interposed between those representing the measured samples. See, for example, US-A-5 515 457.

The amount of interpolation required to form an unbroken line will depend upon a number of factors, including the signal slope. The time available to perform the interpolation, however, is variable and can be very short, depending upon the signal acquisition time and the interval between trigger points.

Aspects of the present invention are set out in the accompanying claims.

According to the present invention there is provided a method and an apparatus for mapping samples to a display memory, in which memory contents representing display elements interposed between elements representing the samples are derived using interpolation. In the preferred embodiment, the display memory is divided up into sections each representing a display column, and mapping of the samples is performed in successive passes, each pass involving deriving the memory contents for each of the columns. Within each pass, memory contents are derived either from the samples themselves or by interpolation, or both. However, the arrangement is such that different passes involve the derivation of different interpolated points.

Using this technique, the display can be built up gradually, so that in each pass picture elements representing the waveform are displayed right across the screen, with intervening picture elements being added to the display in successive passes, until (if desired) the waveform is represented by an unbroken line.

The mapping process can be terminated prior to the interpolation process being completed, if insufficient processing time is available (for example if a new signal acquisition has to be displayed). The technique of the present invention has the advantage that extensive interpolation can be used when sufficient time is available, whereas even if there is insufficient time available a complete (although broken) waveform is nevertheless displayed.

In the preferred embodiment, each mapping process involves successive passes, and the interpolation stage for each pass is predetermined. For example, the first pass may involve mapping the actual samples to the display memory, and possibly deriving a single interpolated point between each pair of successive samples. The second pass may involve deriving interpolated samples situated, for example, at intervals of ¼ and ¾ of the interval between the successive samples. The third pass may involve deriving the interpolated points located at the ⅛, ⅜, ⅝ and ⅞ points, etc.

In the preferred embodiment, when a new mapping process starts, the interpolation stage is not necessarily reset to the first stage. For example, an initial signal acquisition can be mapped to the display, the mapping terminating at, for example, the third interpolation pass. The next signal acquisition can then be mapped to the display, starting at the third interpolation pass. In this way, the displayed waveform can be built up to a continuous, or substantially continuous, line more quickly.

An arrangement embodying the invention will now be described by way of example with reference to the accompanying drawings, in which:

> Figure 1 is a schematic block diagram showing a digital oscilloscope, and particularly the display system thereof;
> Figure 2 is a chart to illustrate the manner in which a waveform is built up using interpolation in successive passes, and
> Figure 3 is a table representing the interpolation pass numbers during which pixels are interpolated, for one particular implementation example.

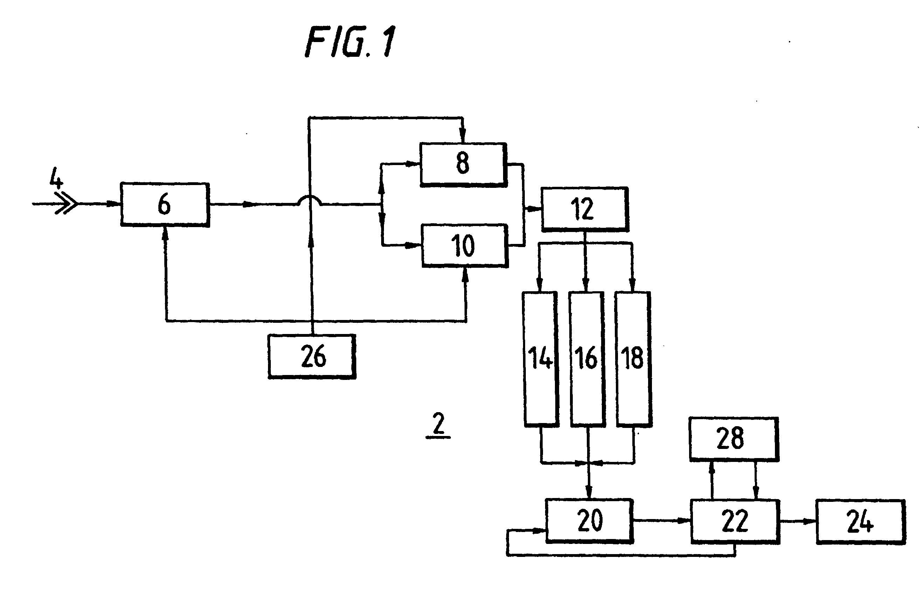

Referring to Figure 1, the oscilloscope 2 has an input terminal 4 coupled to an analog-to-digital converter ("ADC") 6. Samples acquired by the ADC 6 are written into buffer memories 8 and 10, in such a way that each of the buffer memories stores a complete set of samples for a single acquisition interval.

The contents of the buffer memories 8 and 10 are read by an interpolation processor 12 and are written into column intensity memories 14, 16 and 18 (with two of the memories being written to while the other is being read). Each of the intensity memories stores values which are used for a single display column, as will be described in further detail below. Each column stores not only the samples read out of the memories 8 and 10, but also interpolated values derived by the interpolation processor 12.

A brightness processor 20 is capable of receiving the data from each of the column intensity memories 14, 16 and 18, processing this data, and writing the results into a column of a display memory 22, the contents of which define the image on a display screen 24.

The operation of the oscilloscope 2 will be described in more detail below.

A controller 26 is used to set the sample rate and hence the time required for a signal acquisition. After a trigger point is reached, the ADC 6 delivers samples to one of the buffer memories, e.g. memory 8. Samples are delivered to the buffer memory 8 until the end of the acquisition period. When the next trigger point is reached, the ADC 6 will instead deliver the samples to buffer memory 10. Accordingly, throughout the period when one of the buffer memories 8 or 10 is being filled with samples, the other buffer memory is available for repeated reading out of the previously-acquired samples.

The number of acquired samples for each display column will depend upon the acquisition rate and the time base. This number, referred to as the over-sampling ratio ("OSR"), can vary, for example from 1 to 64. Each of the buffer memories 8 and 10 has sufficient capacity to store all the samples for a full screen display. For example, for a display of 256 columns, each buffer memory will comprise 256 x 64 8-bit words.

At any given time, the column intensity memories 14, 16 and 18 represent three successive display columns of the display 24. The memories are used cyclically, so that once the contents of the intensity memory representing, say, the left-most column have been mapped to the display memory 22, that column is then free to be used for the next display column to the right.

At any given time, the interpolation processor 12 is writing data into two of the three Column intensity memories 14, 16 and 18, the third memory being filled with previously-written data and therefore available for reading by the brightness processor 20.

The operation of the interpolation processor 12 will be described in more detail below. However, the result is that each of the column intensity memories 14, 16 and 18 eventually has stored therein a plurality of 12-bit values. Each value is stored in a memory location representing the vertical position, within the respective column on the display, at which a pixel is to be displayed. The contents of the column intensity memory are read out in succession and received by the brightness processor 20. Each 12-bit value is converted into a 2-bit brightness value for the corresponding row and column position in the display memory 22. The values of the three quantiles used to convert the 12-bit value into a 2-bit value can be automatically varied as described in European Patent Application No. 97304952.1, filed 7 July 1997, to provide automatic contrast adjustment.

Each of the thus-derived 2-bit values is then combined, by brightness processor 20, with the current 2-bit value read out of the display memory 22 for that particular row and column position. The 2-bit value resulting from the combination is then stored in the display memory 22 in place of the previous value for that row and column position. The way in which the two values are combined can be varied, again as described in European Patent Application No. 97304952.1, so that the temporal behaviour of the signal (i.e. the manner in which it changes over the course of a number of signal acquisitions) is more easily perceived.

The contents of the display memory 22 are read out, using a separate address counter (not shown), and supplied to the display 24 to form the waveform image.

A decrement processor 28 progressively reduces the contents of each of the storage locations of the display memory 22, so that the trace gradually fades unless it is refreshed by new data.

The interpolation processor 12 operates as follows.

Assuming that a trigger point has been reached, and the ADC 6 starts to write sample values into the buffer memory 10, then the interpolation processor 12 will begin to read values from the buffer memory 8. Each 8-bit value is used to address a respective one of the column intensity memories 14, 16 and 18. The interpolation processor stores into the corresponding location a predetermined value V. Assuming that OSR is greater than 1, then there will be a plurality of sample values for each column. In the preferred embodiment, the interpolation processor 12 stores the predetermined value V into either one of two of the column intensity memories, e.g. column intensity memories 14 and 16, using a stochastic allocation process as described in WO-A-96/37785. The process is such that as the sample number increases so as to approach the boundary between two columns, the probability that the value V will be stored in either one of the adjacent column intensity memories will become more equal. This has a beneficial effect in avoiding aliaising.

Accordingly, for each of the samples read out of the buffer memory 8, the value V is stored in a corresponding location in either column intensity memory 14 or column intensity memory 16. In addition, for each value read out, the interpolation processor calculates the difference $\Delta Y$ between this value and the previous value. If $\Delta Y$ is greater than 1, i.e. if the signal input increased by more than a single unit between successive samples, then the interpolation processor 12 also calculates an interpolated point substantially midway between the two samples, and stores the value V at a location in the column intensity memory 14 or 16 corresponding to this calculated interpolation point. Stochastic allocation can also be used for interpolated values, so that the possibility of the value being stored in column intensity memory 14 or 16 depends on the calculated timing for the interpolated value, which is determined by the sample numbers (i.e. the positions of the samples relative to the column boundaries) of the samples on which interpolation is based, together with the interpolation factor (i.e. the fraction of the sample interval associated with the interpolated value, in this case ½).

The interpolation processor 12 continues by extracting the next sample value from the buffer memory 8, and processes this similarly. This continues until the number of samples which have been read is equal to OSR. At that time, the column intensity memory 14 stores all the relevant samples for the associated column, and the control system switches so that further sample values are written into column intensity memories 16 and 18. The column intensity memory 14 is then read by the brightness processor 20, as described above.

This operation continues until all the display columns of display memory 22 have been written to. This marks the end of the first pass of the interpolation procedure.

The interpolation processor 12 then begins again to read out the contents of the buffer memory 8. This time, each time a value is read out of the buffer memory 8, the value $\Delta Y$ is derived, and from that the interpolation processor 12 calculates the interpolated values which represent samples ¼ and ¾ of the interval between the most recent sample and the preceding sample. These two interpolated values are used to address the appropriate one of the column intensity memories 14, 16 and 18 (as determined by stochastic allocation), and the value V is then stored in the memory thus addressed. Then, the next sample is read out, and again the interpolation processor 12 calculates the values for the ¼ and ¾ unit intervals, to cause the value V to be written into the appropriate memory locations. This is continued until all the memory values from the buffer memory 8 have been read out, which completes pass 2.

Pass 3 is similar, except that in this case the ⅛, ⅜, ⅝ and ⅞ unit values are calculated by interpolation and used to address the appropriate ones of the column intensity memories 14, 16 and 18.

This procedure continues for a maximum of 8 passes. In each pass there are derived interpolated values representing points between the interpolated values in the preceding pass. At the end of 8 passes, even if the difference between successive values is equal to the maximum limit of the ADC 6, i.e. 255, all the intervening interpolated points will have been calculated.

In this embodiment, the value V is set equal to $\dfrac{2^{12}}{2 \times OSR \times \Delta Y}$, which avoids overflow of the intensity memories.

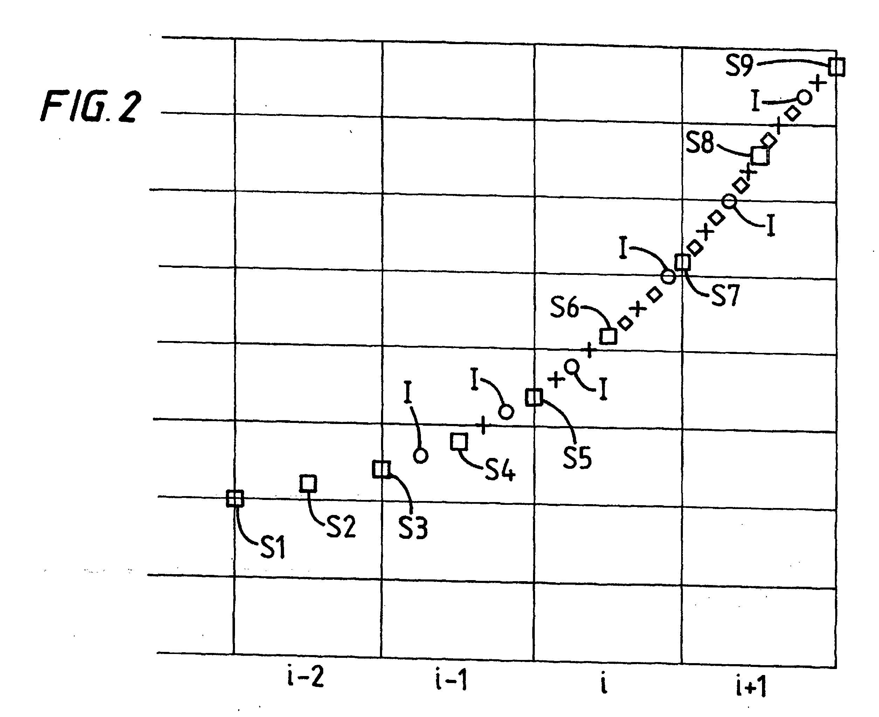

The process is illustrated with reference to Figure 2. Figure 2 is based on an OSR = 2. The symbols in Figure 2 represent the values which are written into the column intensity memories 14, 16 and 18 over the course of several passes, with the corresponding display columns represented by i-2, i-1, i and i i+1. The actual sample values are S1 to S9. For the purpose of illustration, the values within each column are shown as horizontally displaced according to the sweep time, but in the final display they will of course result in a vertical line within a single column of pixels.

The interpolated values calculated during each pass depend upon the pass number and the value of $\Delta Y$. In Figure 2, for each of the values S2 to S9, the value $\Delta Y$ (i.e. the difference between the current value and the preceding value) is, respectively, 1, 1, 2, 3, 4, 5, 7, 6.

The values S1 to S9 are entered in the respective column intensity memories 14 to 18 during the first pass, as are the intervening values I, indicated by circles. During the next pass, the further intervening values marked by crosses are entered into the column intensity memories 14 to 18. During the third pass, the values represented by diamond shapes are entered into the memories.

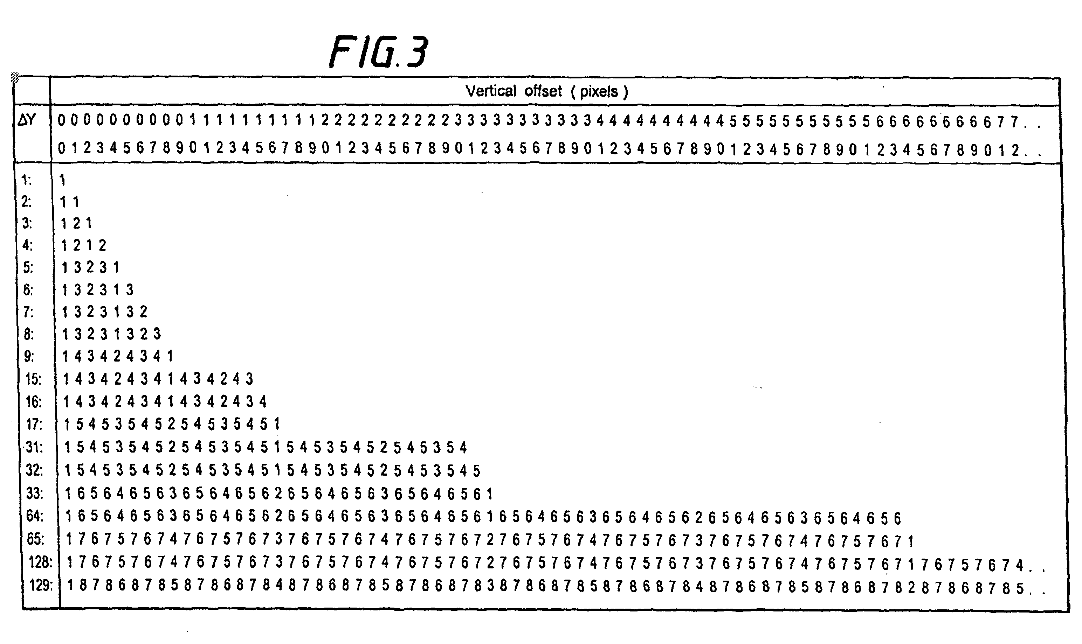

Figure 3 is a table representing the pass number during which an interpolated value is derived, each row representing a different value of $\Delta Y$, and each column representing the vertical offset, in terms of pixel numbers, from the previous sample measurement Y.

For example, taking a $\Delta Y$ value equal to 8, it will be noted that during the first pass the sample itself (at offset equal to 0) is plotted, as is the sample which is midway to the next pixel, at offset 4. During the next pass, the samples at offsets 2 and 6 are plotted, and at the third pass the samples at offsets 1, 3, 5 and 7 are plotted.

For other values of $\Delta Y$ similar procedures are adopted, although the pass numbers tend to vary due to rounding. For example, with $\Delta Y = 9$, the first pass will involve the plotting of the sample at offset 0 and an interpolated value at offset 8, the second pass will plot the value at offset 4, the third at offsets 2 and 6 and the fourth at offsets 1, 3, 5 and 7. However, this does not significantly affect performance, avoids the need for floating-point operations and allows operation using simple bit-shifting calculations.

As soon as a new trigger point occurs, the ADC 6 starts to send values to the other of the buffer memories 8 and 10. Interpolation processor 12 completes the current pass, and then starts to read out the values from the buffer memory 8 or 10 which is no longer being written to by the ADC 6. Assuming that the new trigger occurs before the end of the second pass, then the interpolation processor 12 starts afresh, by plotting the samples S1 to S9 and the intervening interpolated points I. However, if the trigger point occurs after pass 2 has been executed, then the interpolation processor 12 starts to use the new data (e.g. in buffer memory 10), but begins with pass number 3, so that the original samples S1 to S9, and the intervening samples I, and the samples denoted by the crosses in Figure 2 are not plotted immediately, but instead the plotting begins with the samples marked by the diamonds in Figure 2. This causes a more rapid completion of interpolation, but means that the displayed waveform will be derived from a mixture of two acquisitions. This could be varied (e.g. by always restarting at pass 1, or by starting at the pass number following the one most recently completed for the preceding acquisition), but the technique of the preferred embodiment offers a good compromise.

The process continues until the end of the eighth pass. If no trigger has then been reached, the plotting begins again, by setting the pass number equal to one and thereby plotting the actual sample values S1 to S9 and the intermediate values I.

Various modifications to this embodiment are possible. Switch means may be provided to allow an operator to adjust the interpolation process. The operator may be able to (i) disable interpolation, (ii) limit interpolation to the first pass, or the first few passes, (iii) control whether or not new acquisitions interrupt the interpolation process, and/or (iv) determine how the initial pass number is calculated when a new acquisition is to be mapped. It is not necessary to use stochastic allocation. Also, it is not necessary to have three column intensity memories 14, 16 and 18. There could be a pair of memories, one of which is written to while the other is read. Alternatively, there could be just a single memory which is read out as new samples are read in. It is not necessary to have the brightness processor 20 combine the values from the intensity memory with current values in the display memory 22. The samples from the analog-to-digital converter can if desired be directed straight to a display memory 22 instead of using a buffer memory 8 or 10 and a column intensity memory 14, 16 or 18. Although the display memory 22 is shown as separate from the display 24, it could form part of the display, particularly if the display 24 is of a type in which each pixel has storage characteristics.

In the illustrated embodiment, the functional elements are shown as discrete blocks, and indeed could be implemented by discrete hardware. Alternatively, some or all could be implemented by an appropriately programmed microprocessor and associated read/write memory.

## Claims

1. A method of mapping data samples, which represent an input waveform acquired during an acquisition period, to a memory whose contents interpolating are used to define an image on a screen display (24), the method comprising the data samples to derive memory contents representing display elements corresponding to parts of the waveform between data samples, wherein the mapping occurs during a plurality of successive passes, each pass involving deriving memory contents for display columns distributed throughout the display region, and wherein each pass involves deriving different interpolated memory contents.

2. A method as claimed in claim 1, further including an initial pass which involves deriving memory contents representing data samples.

3. A method as claimed in claim 2, wherein the initial pass involves additionally deriving memory contents corresponding to parts of the waveform between the data samples.

4. A method as claimed in any preceding claim, including the step of interrupting the mapping process in order to map samples acquired during a subsequent acquisition period.

5. A method as claimed in claim 4, wherein the mapping process involves a succession of passes in each of which a different predetermined interpolation stage is performed, and wherein the stage of interpolation performed after commencement of a mapping process for a subsequent acquisition period depends upon the stage reached during the mapping operation for the preceding acquisition period.

6. A method as claimed in any preceding claim, in which the memory is a relatively high resolution intensity memory, the contents of which are subsequently mapped to a relatively low resolution display memory (22) and determine the brightness of display elements.

7. A method as claimed in claim 6, in which the display memory (22) stores data representing the display image for columns of the display (24), and in which the high resolution intensity memory is used successively to derive the contents for a plurality of such columns.

8. A method as claimed in claim 6 or 7, including a plurality of high resolution intensity memories each used to derive the contents for columns of the display memory (22), and in which each sample is stored in one of said high resolution intensity memories which is selected on the basis of a stochastic allocation dependent upon the sample number.

9. A method as claimed in any preceding claim, including first and second buffer memories (8,10) each arranged to store data samples acquired during a respective acquisition period, the mapping process being arranged to read out the memory of one buffer memory (8) while the other buffer memory (10) is being written to.

10. Apparatus for mapping data samples representing an input waveform acquired during an acquisition period, the apparatus comprising means arranged to carry out the steps of a method as claimed in any preceding claim.

## Patentansprüche

1. Verfahren zur Abbildung von einen während einer Erfassungsperiode erfaßten Eingangssignalverlauf darstellenden Datenabtastwerten in einen Speicher, dessen Inhalte zur Definition eines Bilds auf einem Bildschirm (24) verwendet werden, mit einem Interpolieren der Datenabtastwerte zur Ableitung von Speicherinhalten, die Teilen des Signalverlaufs zwischen Datenabtastwerten entsprechende Anzeigeelemente darstellen, wobei die Abbildung während einer Vielzahl von aufeinanderfolgenden Durchläufen auftritt, wobei jeder Durchlauf ein Ableiten von Speicherinhalten für überall in dem Anzeigebereich verteilte Anzeigespalten umfaßt und wobei jeder Durchlauf ein Ableiten verschiedener interpolierter Speicherinhalte umfaßt.

2. Verfahren nach Anspruch 1, ferner mit einem anfänglichen Durchlauf, der ein Ableiten von Datenabtastwerte darstellenden Speicherinhalten umfaßt.

3. Verfahren nach Anspruch 2, wobei der anfängliche Durchlauf ein zusätzliches Ableiten von Teilen des Signalverlaufs zwischen den Datenabtastwerten entsprechenden Speicherinhalten umfaßt.

4. Verfahren nach einem der vorstehenden Ansprüche, mit dem Schritt des Unterbrechens des Abbildungsprozesses zur Abbildung von während einer nachfolgenden Erfassungsperiode erfaßten Abtastwerten.

5. Verfahren nach Anspruch 4, wobei der Abbildungsprozeß eine Folge von Durchläufen umfaßt, in denen jeweils eine verschiedene vorbestimmte Interpolationsstufe durchgeführt wird, und wobei die nach dem Beginn eines Abbildungsprozesses für eine nachfolgende Erfassungsperiode durchgeführte Interpolationsstufe von der während der Abbildungsoperation für die vorhergehende Erfassungsperiode erreichten Stufe abhängt.

6. Verfahren nach einem der vorstehenden Ansprüche, bei dem der Speicher ein Intensitätsspeicher mit einer relativ hohen Auflösung ist, dessen Inhalte anschließend in einen Anzeigespeicher (22) mit einer relativ niedrigen Auflösung abgebildet werden und die Helligkeit von Anzeigeelementen bestimmen.

7. Verfahren nach Anspruch 6, bei dem der Anzeigespeicher (22) das Anzeigebild für Spalten der Anzeige (24) darstellende Daten speichert und bei dem der Intensitätsspeicher mit einer hohen Auflösung anschließend zur Ableitung der Inhalte für eine Vielzahl derartiger Spalten verwendet wird.

8. Verfahren nach Anspruch 6 oder 7, mit einer Vielzahl von Intensitätsspeichern mit einer hohen Auflösung, die jeweils zur Ableitung der Inhalte für Spalten des Anzeigespeichers (22) verwendet werden, und wobei jeder Abtastwert in einem der Intensitätsspeicher mit einer hohen Auflösung gespeichert wird, der auf der Grundlage einer von der Abtastwertzahl abhängigen stochastischen Zuordnung ausgewählt wird.

9. Verfahren nach einem der vorstehenden Ansprüche, mit einem ersten und zweiten Zwischenspeicher (8, 10), die jeweils zur Speicherung von während einer jeweiligen Erfassungsperiode erfaßten Datenabtastwerten ausgelegt sind, wobei der Abbildungsprozeß dazu ausgelegt ist, den Speicher eines Zwischenspeichers (8) auszulesen, während in den anderen Zwischenspeicher (10) geschrieben wird.

10. Vorrichtung zur Abbildung von einen während einer Erfassungsperiode erfaßten Eingangssignalverlauf darstellenden Datenabtastwerten, wobei die Vorrichtung eine zur Ausführung der Schritte eines Verfahrens nach einem der vorstehenden Ansprüche ausgelegte Einrichtung umfaßt.

**Revendications**

1. Procédé de mise en correspondance d'échantillons de données, qui représentent une forme d'onde d'entrée acquise au cours d'une période d'acquisition, avec une mémoire dont le contenu sert à définir une image sur un écran d'affichage (24), le procédé comprenant l'interpolation des échantillons de données pour dériver le contenu de la mémoire représentant les éléments d'affichage correspondant à des parties de formes d'onde présentes entre les échantillons de données, dans lequel la mise en correspondance se produit au cours d'une pluralité de passages successifs, chacun des passages impliquant la dérivation du contenu de la mémoire pour des colonnes d'affichage distribuées dans l'ensemble de la région d'affichage, et dans lequel chacun des passages implique la dérivation de différents contenus de mémoire interpolés.

2. Procédé selon la revendication 1, comprenant en outre un passage initial qui implique la dérivation du contenu de la mémoire représentant des échantillons de données.

3. Procédé selon la revendication 2, dans lequel le passage initial implique la dérivation supplémentaire du contenu de la mémoire correspondant à des parties de la forme d'onde situées entre les échantillons de données.

4. Procédé selon l'une quelconque des revendications précédentes, comprenant l'étape consistant à interrompre le processus de mise en correspondance afin de mettre en correspondance des échantillons acquis lors d'une période d'acquisition ultérieure.

5. Procédé selon la revendication 4, dans lequel le processus de mise en correspondance implique une succession de passages au cours desquels une étape d'interpolation prédéterminée différente est mise en oeuvre, et dans lequel l'étape d'interpolation mise en oeuvre au-delà du commencement d'un processus de mise en correspondance au cours d'une période d'acquisition ultérieure dépend de l'étape atteinte lors de l'opération de mise en correspondance au cours de la période d'acquisition précédente.

6. Procédé selon l'une quelconque des revendications précédentes, dans lequel la mémoire est une mémoire d'intensité de résolution relativement élevée, dont le contenu est mis en correspondance ultérieurement avec une mémoire d'affichage de résolution relativement faible (22) et détermine la luminosité des éléments d'affichage.

7. Procédé selon la revendication 6, dans lequel la mémoire d'affichage (22) contient des données représentant les images à afficher pour les colonnes de l'afficheur (24), et dans lequel la mémoire d'intensité à résolution élevée est utilisée successivement pour dériver le contenu correspondant à une pluralité de ces colonnes.

8. Procédé selon la revendication 6 ou la revendication 7, comprenant une pluralité de mémoires d'intensité de résolution élevée utilisées pour dériver le contenu des colonnes de la mémoire d'affichage (22), et dans lequel chacun des échantillons est stocké dans une desdites mémoires d'intensité à résolution élevée sélectionnée en fonction d'une affectation stochastique qui dépend du nombre d'échantillons.

9. Procédé selon l'une quelconque des revendications précédentes, comprenant des première et seconde mémoires tampon (8, 10) disposées pour stocker les échantillons de données acquis lors d'une période d'acquisition respective, le processus de mise en correspondance étant conçu pour permettre la lecture d'une mémoire tampon (8) alors qu'a lieu l'écriture de l'autre mémoire tampon (10).

10. Dispositif de mise en correspondance d'échantillons de données représentant une forme d'onde d'entrée acquise lors d'une période d'acquisition, le dispositif comprenant un moyen conçu pour la mise en oeuvre des étapes d'un procédé selon l'une quelconque des revendications précédentes.

FIG.1

FIG.2

S9
I
S8
I
S6
S7
I
I
I
S4
S5
I
S1
S2
S3

i-2    i-1    i    i+1

EP 0 919 818 B1

9

# FIG.3

EP 0 919 818 B1

| | Vertical offset ( pixels ) |
|---|---|
| ΔY | 0 0 0 0 0 0 0 0 0 0 1 1 1 1 1 1 1 1 1 1 2 2 2 2 2 2 2 2 2 2 3 3 3 3 3 3 3 3 3 3 4 4 4 4 4 4 4 4 4 4 5 5 5 5 5 5 5 5 5 5 6 6 6 6 6 6 6 6 6 6 7 7 . . |
| | 0 1 2 3 4 5 6 7 8 9 0 1 2 3 4 5 6 7 8 9 0 1 2 3 4 5 6 7 8 9 0 1 2 3 4 5 6 7 8 9 0 1 2 3 4 5 6 7 8 9 0 1 2 3 4 5 6 7 8 9 0 1 2 3 4 5 6 7 8 9 0 1 2 . . |
| 1: | 1 |
| 2: | 1 1 |
| 3: | 1 2 1 |
| 4: | 1 2 1 2 |
| 5: | 1 3 2 3 1 |
| 6: | 1 3 2 3 1 3 |
| 7: | 1 3 2 3 1 3 2 |
| 8: | 1 3 2 3 1 3 2 3 |
| 9: | 1 4 3 4 2 4 3 4 1 |
| 15: | 1 4 3 4 2 4 3 4 1 4 3 4 2 4 3 |
| 16: | 1 4 3 4 2 4 3 4 1 4 3 4 2 4 3 4 |
| 17: | 1 5 4 5 3 5 4 5 2 5 4 5 3 5 4 5 1 |
| 31: | 1 5 4 5 3 5 4 5 2 5 4 5 3 5 4 5 1 5 4 5 3 5 4 5 2 5 4 5 3 5 4 |
| 32: | 1 5 4 5 3 5 4 5 2 5 4 5 3 5 4 5 1 5 4 5 3 5 4 5 2 5 4 5 3 5 4 5 |
| 33: | 1 6 5 6 4 6 5 6 3 6 5 6 4 6 5 6 2 6 5 6 4 6 5 6 3 6 5 6 4 6 5 6 1 |
| 64: | 1 6 5 6 4 6 5 6 3 6 5 6 4 6 5 6 2 6 5 6 4 6 5 6 3 6 5 6 4 6 5 6 1 6 5 6 4 6 5 6 3 6 5 6 4 6 5 6 2 6 5 6 4 6 5 6 3 6 5 6 4 6 5 6 |
| 65: | 1 7 6 7 5 7 6 7 4 7 6 7 5 7 6 7 3 7 6 7 5 7 6 7 4 7 6 7 5 7 6 7 2 7 6 7 5 7 6 7 4 7 6 7 5 7 6 7 3 7 6 7 5 7 6 7 4 7 6 7 5 7 6 7 1 |
| 128: | 1 7 6 7 5 7 6 7 4 7 6 7 5 7 6 7 3 7 6 7 5 7 6 7 4 7 6 7 5 7 6 7 2 7 6 7 5 7 6 7 4 7 6 7 5 7 6 7 3 7 6 7 5 7 6 7 4 7 6 7 5 7 6 7 1 7 6 7 5 7 6 7 4 . . |
| 129: | 1 8 7 8 6 8 7 8 5 8 7 8 6 8 7 8 4 8 7 8 6 8 7 8 5 8 7 8 6 8 7 8 3 8 7 8 6 8 7 8 5 8 7 8 6 8 7 8 4 8 7 8 6 8 7 8 5 8 7 8 6 8 7 8 2 8 7 8 6 8 7 8 5 . . |